(19) Europäisches Patentamt
European Patent Office
Office européen des brevets

(11) Veröffentlichungsnummer: **0 146 505**
**B1**

# (12) EUROPÄISCHE PATENTSCHRIFT

(45) Veröffentlichungstag der Patentschrift: **04.04.90**

(51) Int. Cl.[5]: **G 03 F 7/16,** G 03 F 7/26

(21) Anmeldenummer: **84810618.3**

(22) Anmeldetag: **14.12.84**

## (54) Verfahren zur Bilderzeugung.

(30) Priorität: **20.12.83 GB 8333853**

(43) Veröffentlichungstag der Anmeldung:
**26.06.85 Patentblatt 85/26**

(45) Bekanntmachung des Hinweises auf die Patenterteilung:
**04.04.90 Patentblatt 90/14**

(84) Benannte Vertragsstaaten:
**BE CH DE FR GB IT LI NL SE**

(56) Entgegenhaltungen:
**FR-A-2 226 694**
**FR-A-2 495 025**
**US-A-4 289 798**
**US-A-4 291 118**
**US-A-4 389 433**

(73) Patentinhaber: **CIBA-GEIGY AG**
**Klybeckstrasse 141**
**CH-4002 Basel (CH)**

(72) Erfinder: **Irving, Edward, Dr.**
**41, Swaffham Road**
**Burwell Cambridge CB5 0AN (GB)**
Erfinder: **Smith, Terence James**
**6A, Dickasons Melbourn**
**Royston Hertfordshire SG8 6EL (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 146 505 B1

**Beschreibung**

Die vorliegende Erfindung betrifft ein Verfahren zur Bilderzeugung mittels Dampfpermeation, gefolgt von Bestrahlung mit aktinischem Licht.

Im allgemeinen erfolgt die Bilderzeugung mittels Photopolymerisation dadurch, dass man ein Substrat mit einer Lösung einer photopolymerisierbaren Substanz in einem flüchtigen organischen Lösungsmittel beschichtet, das Lösunsmittel verdampft oder verdampfen lässt, wobei ein Film der photopolymerisierbaren Substanz entsteht, diesen Film mit aktinischem Licht bestrahlt, z.B. durch ein Negativ, wodurch die bestrahlten Stellen des Films photopolymerisiert und damit weniger löslich werden, während die nicht bestrahlten Stellen im wesentlichen unverändert bleiben, und schliesslich die nicht bestrahlten, nicht photopolymerisierten Stellen des Films mit einem geeigneten Lösungsmittel weglöst, das die bestrahlten photopolymerisierten Stellen nicht löst. Diese letzte Stufe ist allgemein als "Entwickeln" bekannt.

Es besteht ein Bedürfnis nach einem Verfahren, bei dem Substrate in Abwesenheit von organischen Lösungsmitteln mit photopolymerisierbaren Substanzen beschichtet und diese Beschichtung in einen im wesentlichen festen, nicht-klebrigen und für die Bestrahlung bereiten Zustand übergeführt werden können. Damit könnte in dieser Phase nicht nur auf die Verwendung von Lösungsmitteln, die Probleme der Entflammbarkeit und Rückgewinnungskosten verursachen können, verzichtet werden, sondern es würde auch die Herstellung von beschichteten, für die Bestrahlung bereiten Substraten in einem kontinuierlichen Verfahren erleichtert.

Es wurde nun gefunden, dass dieses Ziel durch Verwendung bestimmter flüssiger Stoffgemische mit Gruppen, welche die Polymerisation mittels Dampfpermeation und die Vernetzung (Härtung) unter Lichteinfluss ermöglichen, erreicht werden kann. Diese Gruppen können Bestandteil eines einzigen Moleküls sein oder sie können in verschiedenen Molekülen vorliegen. Die Gruppen werden so gewählt, dass sich Schichten aus flüssigen Stoffgemischen mittels Dampfpermeations-Polymerisation schnell in feste, im wesentlichen klebfreie Schichten überführen lassen, die jedoch in bestimmten Lösungsmitteln noch löslich sind. Falls erwünscht, kann ein Teil oder können Teile der Schicht mit aktinischem Licht bestrahlt werden, wobei in der schon polymerisierten Schicht eine Vernetzung unter Lichteinfluss erfolgt. Dabei werden die Teile der Schicht, die sich unter Lichteinfluss härten bzw. vernetzen lassen, gegenüber dem Lösungsmittel bedeutend weniger löslich.

In der U.S. Patentschrift Nr. 4,291,118 wird ein Verfahren zum Erzeugen von Reliefabbildungen aus Filmen aus einem flüssigen photopolymerisierbaren Material beschrieben. Dabei wird der Film bis zur Verfestigung einer chemischen Härtung unterzogen, und der verfestigte Film wird in einem bestimmten vorgegebenen Muster so behandelt, dass in dem verfestigten Film entsprechend dem Muster an den behandelten und nicht behandelten Stellen unterschiedliche chemische Zustände entstehen. Anschliessend wird selektiv der Teil der Masse in dem einen chemischen Zustand entfernt, wobei der Teil der Masse in dem anderen chemischen Zustand ein Reliefbild bildet. Um die unterschiedlichen chemischen Zustände zu erzeugen, wird in allen beschriebenen Ausführungsformen aktinisches Licht angewendet.

Bei dem in dieser U.S. Patentschrift beschriebenen Verfahren wird somit der Film aus flüssigem Material mit aktinischem Licht bestrahlt, und der verfestigte Film wird anschliessend erneut in einem vorgegebenen Muster mit aktinischem Licht bestrahlt, so dass sich ein Teil oder Teile des Films weniger leicht mit Lösungsmitteln entfernen lassen. Schliesslich wird das Bild entwickelt, indem man mit dem Lösungsmittel die leichter entfernbaren Teile, d.h. die nicht ein zweites Mal bestrahlten Teile, auswäscht. Die Bestrahlungsbedingungen müssen bei diesem Verfahren sehr genau eingehalten werden. Bei ungenügender Bestrahlung in der ersten Stufe bleibt das verfestigte Material klebrig und unangenehm in der Handhabung. Wird es zuviel bestrahlt, so erhält man Bilder mit ungenügender Auflösung. Es wird nur die Verwendung von photopolymerisierbaren Polyen-Polythiol-Stoffgemischen beschrieben. Diese haben bei dem in der U.S. Patentschrift beschriebenen Verfahren den Nachteil, dass die durch die Bestrahlung mit aktinischem Licht initiierte Polymerisation weitergeht, wenn die Bestrahlung unterbrochen wird. Daraus folgt, dass zum Erzielen Bilder guter Qualität die zweite Bestrahlung sofort vorgenommen werden muss. Dies beeinträchtigt die industrielle Anwendung dieses Verfahrens.

Aus der FR—A—2,226,694 ist ein Verfahren bekannt, wobei ein photovernetzbares Polymeres zunächst kurzzeitig ganzflächig bestrahlt wird und dann zum Aushärten in ausgewählten Bereichen bildmässig bestrahlt wird. Mit dem Verfahren lassen sich Druckplatten in zeitsparender Art und Weise herstellen.

Das Härten mittels Dampfpermeation stellt ein bekanntes Verfahren dar, bei dem ein flüssiges polymerisierbares Stoffgemisch dem Dampf eines Reagens ausgesetzt wird, das mit dem Stoffgemisch reagiert oder dessen Härtung katalysiert. Dabei wird das Stoffgemisch vom flüssigen in den festen Zustand übergeführt. Als Dämpfe werden im allgemeinen Ammoniak- oder Amindämpfe verwendet. Das polymerisierbare Stoffgemisch enthält üblicherweise ein Polyisocyanat und ein Polyol. In der U.S. Patentschrift Nr. 4,343,839 wird z.B. eine Beschichtungsmasse beschrieben, die (A) ein aromatisches Kondensationsprodukt mit OH-Gruppen, (B) ein polyisocyanat, (C) ein flüchtiges organisches Lösungsmittel für (A) und (B), und (D) ein das Abscheuern verhinderndes Mittel enthält. Diese Stoffgemische lassen sich unter der Einwirkung von Dämpfen eines tertiären Amins schnell härten und ergeben transparente flexible Beschichtungen mit hohem Glanz.

Nach dem in der U.S. Patentschrift Nr. 4,343,924 beschriebenen Verfahren zum Beschichten von Substraten werden (a) ein Kondensat mit phenolischen OH-Gruppen, (b) ein Polyisocyanat und (c) ein

organisches Lösungsmittel verwendet. Diese Beschichtungen lassen sich unter Einwirkung von Dämpfen eines tertiären Amin-Katalysators schnell härten.

Die U.S. Patentschrift Nr. 4,368,222 beschreibt ein Verfahren zum Beschichten von porösen Substraten unter Verwendung eines hitzehärtbaren Stoffgemisches, das eine aromatische Hydroxylverbindung und einen Polyisocyanat-Härter enthält. Die Härtung erfolgt durch Einwirken von Dämpfen eines tertiären Amins auf das beschichtete Substrat. Gemäss der U.S. Patentschrift Nr. 4,374,181 werden Stoffgemische, enthaltend eine hydroxy-aromatische Verbindung, einen Polyisocyanat-Härter und ein organisches Lösungsmittel, bei Raumtemperatur unter der Einwirkung von tertiären Aminen in Dampfform gehärtet. Die Beschichtungen sollen sich vor allem für nach dem Spritzgussverfahren hergestellte Gegenstände, besonders flexible Polyurethanartikel, wie Fahrzeugstoss-Stangen oder Vinyl-Möbelüberzugsmaterialien, eignen.

In der britischen Patentschrift Nr. 1,351,881 sind Stoffgemische beschrieben, die beim Kontakt mit Aminen, besonders dampfförmigen Aminen, härten. Sie enthalten Polyisocyanate und ein Reaktionsprodukt mit freien phenolischen Hydroxylgruppen aus (1) einem Phenol-Aldehyd-Kondensat und (2) einer Verbindung mit zwei oder mehr funktionellen Gruppen, ausgewählt aus Epoxid-, Hydroxyl- oder Carbonsäuregruppen.

Gemäss der britischen Patentschrift Nr. 1,369,351 enthalten Stoffgemische, die sich im Kontakt mit Aminen, besonders in Dampfform, härten lassen, ein Polyisocyanat und eine Komponente mit freien Hydroxyl- oder Epoxidgruppen, die mit einer Diphenolsäure der Formel I

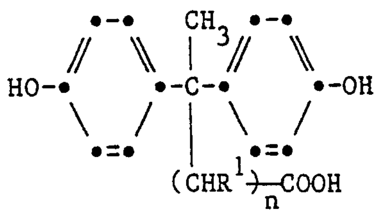

(I)

verkappt sind, worin $R^1$ ein Wasserstoffatom oder eine Alkylgruppe und n eine ganze Zahl von 1—8 darstellen. Diese Verbindung kann auch in Form eines Esters vorliegen, wenn sie zum Verkappen von freien Hydroxylgruppen verwendet wird.

In der britischen Patentanmeldung Nr. 2,093,049 ist ein Verfahren zum Härten von Verbindungen beschrieben, die mindestens zwei Isocyanatgruppen aufweisen, die über eine Methylengruppe eines Urethanharzes mit endständigen Isocyanatgruppen an einen aromatischen Ring gebunden sind. Die Härtung erfolgt durch Behandlung mit Dämpfen eines tertiären Amins.

Gemäss der U.S. Patentschrift Nr. 4,173,682 werden zum Härten von Beschichtungsmaterialien auf der Basis von Urethanen sowohl Bestrahlung als auch Dampfpermeation eingesetzt. Die Beschichtungsmaterialien enthalten A) ein Addukt mit Isocyanatgruppen aus a) einem Acrylsäure- oder Methacrylsäurehydroxyester und b) einem Polyisocyanat, b) eine mehrwertige Hydroxyverbindung und c) einen Photoinitiator. Diese Stoffgemische werden durch Bestrahlen und anschliessende Reaktion mit Wasserdampf gehärtet. In der genannten U.S. Patentschrift ist kein Hinweis zu finden, dass die Reaktion mit Wasserdampf vor der Bestrahlung erfolgen könnte.

Auch gemäss der U.S. Patentschrift Nr. 4,289,798 wird die Härtung sowohl mit Bestrahlung als auch mit Dampfpermeation durchgeführt. Gemäss dieser patentschrift wird ein flüssiges harzartiges Stoffgemisch mindestens teilweise durch Strahlungsenergie gehärtet, zur Verminderung des Glanzes mit Koronaentladung behandelt und dann zur Vervollständigung der Härtung Strahlungsenergie und gegebenenfalls Feuchtigkeit ausgesetzt. Es sind keine Hinweise darauf zu finden, dass durch die Behandlung mit Feuchtigkeit allein eine teilweise Härtung des Stoffgemisches zu einer festen aber immer noch lichtvernetzbaren Schicht erzielt werden könnte, die dann zur Vernetzung der belichteten Stellen bildmässig mit aktinischer Strahlung belichtet werden kann, wobei die nicht belichteten Stellen in Entwicklern löslich bleiben.

Die Verwendung von Wasserdampf zum teilweisen Härten von Stoffgemischen wird in der U.S. Patentschrift Nr. 4,073,975 beschrieben. Gemäss dieser Patentschrift wird mit einem Polyurethan-Stoffgemisch aus einem cycloaliphatischen Diisocyanat, einem Polyalkylenätherpolyol und einem Polyesterpolyol ein Trägermaterial beschichtet, dann zum Entfernen des Glanzes und teilweisen Härten mit Wasserdampf behandelt und schliesslich zum Aushärten erhitzt. Ein Bestrahlen wird nicht in Betracht gezogen.

Die Verwendung von alkalischen Dämpfen zum Härten von nicht-isocyanat-haltigen Beschichtungsmaterialien ist in der U.S. Patentschrift Nr. 2,710,815 und 3,085,987 beschrieben. Gemäss der erstgenannten Patentschrift wird eine ein Protein, wie Gelatine, und ein wasserlösliches Aluminiumsalz enthaltende Lösung durch Kontakt mit Ammoniakgas gehärtet. Gemäss der zweiten Patentschrift wird mit einer durch Emulsionspolymerisation eines äthylenisch ungesättigten Monomeren und eines carboxylgruppen-haltigen Monomeren erhaltenen Emulsion eine Oberfläche beschichtet und mit einem stickstoffhaltigen alkalischen Gas, wie Ammoniak, behandelt.

In der U.S. Patentschrift Nr. 4,389,433 wird ein Verfahren zum Härten von monomeren Acrylaten und

Methacrylaten beschrieben, indem man diese Monomere mit einem freie Radikale bildenden Hydroperoxid vermischt und das Gemisch bei Raumtemperaturen während einiger Sekunden mit Schwefeldioxid behandelt. Geeignete freie Radikalbildner sind z.B. Wasserstoffperoxid, Cumolhydroperoxid und 2,4-Dimethyl-2,4-hexandihydroperoxid. Als Monomere eignen sich z.B. die Acrylate und Methacrylate von 1,6-Hexandiol, Trimethylolpropan, Polypropylenglykol und Allylalkohol.

Die britische Patentanmeldung Nr. 2,010,880 offenbart Beschichtungsmaterialien, die ein Gemisch aus ungesättigten Acrylaten, die frei von aktiven OH-Gruppen sind, und einem Präpolymer mit Isocyanat-Endgruppen, erhalten aus einem Polyesterdiol-/Polyestertriol-Gemisch und einem aliphatischen Diisocyanat, enthalten. Mit diesen Gemischen werden Oberflächen beschichtet und diese werden dann zum Härten und Vernetzen der ungesättigten Teile der Beschichtung unter einer UV-Lichtquelle hindurchgeführt. Wird die teilweise gehärtete Beschichtung dem Einfluss von Feuchtigkeit ausgesetzt, so findet durch Reaktion der Isocyanatgruppe eine Kettenverlängerung und eine Vernetzung statt. Die erhaltenen voll ausgehärteten Beschichtungen sind zäh, glänzend und resistent gegen Beschädigungen.

Keine der oben diskutierten Patentschriften und Patentanmeldungen offenbart ein Verfahren, bei dem durch Härten mittels Dampfpermeation Beschichtungen erhalten werden, die in bestimmten Lösungsmitteln noch löslich sind, und bei dem völlige Unlöslichkeit durch Bestrahlung bewirkt wird, so dass Abbildungen erzeugt werden können.

Gegenstand der Erfindung ist daher ein Verfahren zur Bilderzeugung, indem man

a) auf ein Substrat eine Schicht eines flüssigen Stoffgemisches appliziert, das durch Kontakt mit einem gasförmigen Polymerisationsmittel polymerisierbare Reste und lichtvernetzbare Reste aufweist,

b) das Stoffgemisch mit einem gasförmigen Polymerisationsmittel in Kontakt bringt, wobei sich die Schicht verfestigt, aber lichtvernetzbar bleibt,

c) die verfestigte Schicht in einem vorgegebenen Muster mit aktinischem Licht bestrahlt, so dass die belichteten Stellen der Schicht durch Licht vernetzt werden, und

d) die im wesentlichen nicht lichtvernetzten Stellen der Schicht durch Behandlung mit einem dafür geeigneten Lösungsmittel entfernt.

Der Ausdruck "in einem vorgegebenen Muster bestrahlt" umfasst sowohl das Bestrahlen durch ein ein Bild aufweisendes transparentes Material als auch das Bestrahlen mit einem computergesteuerten, ein Bild erzeugenden Laserstrahl.

Das in der Stufe a) des neuen erfindungsgemässen Verfahrens auf ein Substrat applizierte flüssige Stoffgemisch kann Substanzen enthalten, welche die polymerisierbaren und lichtvernetzbaren Gruppen in demselben Molekül aufweisen, oder es kann ein Gemisch aus einem oder mehreren Materialien, die im Kontakt mit dem gasförmigen Polymerisationsmittel polymerisiert werden können, zusammen mit einer oder mehreren lichtvernetzbaren Substanzen enthalten.

Die polymerisierbaren Reste können ihrerseits eine einzige Spezies oder zwei oder mehr ähnliche Spezies aufweisen, die unter der katalytischen Einwirkung des gasförmigen Polymerisationsmittels polymerisieren, oder sie können zwei oder mehr miteinander reagierende Spezies aufweisen, die vergleichsweise stabil sind, bis deren Reaktion untereinander durch das gasförmige Polymerisationsmittel katalysiert oder beschleunigt wird.

Das gasförmige Polymerisationsmittel ist eine Substanz, welche entweder die Polymerisation einer einzigen Spezies oder die Copolymerisation von zwei oder mehr ähnlichen Spezies initiiert oder katalysiert oder als Katalysator oder Beschleuniger für eine polymerbildende Reaktion zwischen zwei oder mehr Co-Reaktanden wirkt. Solche Materialien können neutral, basisch oder sauer sein, und deren Wahl hängt von der Natur des zu polymerisirenden Materials ab.

Der Ausdruck "gasförmig" wird lediglich zur Bezeichnung der physikalischen Form, in welcher das Polymerisationsmittel mit der polymerisierbaren Spezies in Kontakt kommt, verwendet. Dieser Begriff umfasst nicht nur Substanzen, die bei Raumtemperatur gasförmig sind, sondern auch flüssige Substanzen, die im Kontakt mit inerten Trägergasen bei Raumtemperatur oder erhöhten Temperaturen leicht gasförmige Gemische bilden.

Für die Ausführungsform, bei welcher das gasförmige Polymerisationsmittel die polymerisation oder Copolymerisation initiiert oder katalysiert, eignen sich z.B. die folgenden polymerisierbaren Reste und dafür einsetzbaren gasförmigen Polymerisationsmittel: Cyanacrylate mit Wasserdampf, Ammoniak oder einem Amin, Isocyanat-Präpolymere mit Ammoniak oder einem Amin, Epoxidharze mit Bortrifluorid und phenolische Harze mit sauren Gasen.

Für die Ausführungsform, bei welcher das gasförmige Polymerisationsmittel als Katalysator oder Beschleuniger für eine polymerbildende Reaktion zwischen zwei oder mehr Co-Reaktanden wirkt, eignen sich beispielsweise die folgenden polymerisierbaren Reste und dafür einsetzbaren gasförmigen Polymerisationsmittel: Gemische aus einem Polyol und einem Isocyanat mit Ammoniak oder einem Amin, Polyen-Polythiol-Gemische mit Ammoniak oder einem Amin, Gemische aus Epoxidharzen und Aminen mit einem sauren Gas, Gemische aus Epoxidharzen und Thiolen mit Ammoniak und einem Amin, Gemische aus einem Acrylat oder Methacrylat und Wasserstoffperoxid oder einem freie Radikale bildenden Hydroperoxid und Schwefeldioxid.

Bevorzugte Amine zur Verwendung als gasförmiges Polymerisationsmittel sind z.B. Methylamin, Dimethylamin, Trimethylamin, Aethylamin, Diäthylamin, Triäthylamin, Isopropylamin, tert.-Butylamin, Aethanolamin, Triäthanolamin und N,N-Dimethyläthanolamin. Als Beispiele von geeigneten sauren Gasen

seien Chlorwasserstoff, Bromwasserstoff, Schwefeldioxid und Schwefeltrioxid genannt.

Als Cyanacrylate, die im erfindungsgemässen Verfahren eingesetzt werden können, eignen sich z.B. Verbindungen der Formel II

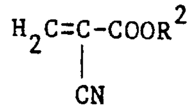 (II),

worin $R^2$ höchstens 18 C-Atome aufweist und eine Alkyl-, Alkenyl-, Aralkyl-, Halogenalkyl-, Cycloalkyl-, Aryl- oder Alkoxyalkylgruppe, besonders eine Methyl-, Aethyl-, Allyl-, Benzyl-, Chlormethyl-, Cyclohexyl-, Phenyl- oder Aethoxyäthylgruppe, ist.

Als Gemische aus Polyolen und Isocyanaten können z.B. Gemische aus Diolen, beispielsweise Alkylenglykolen, wie Aethylenglykol, 1,4-Butandiol und Bis(hydroxymethyl)cyclohexan, und Polyoxyalkylenglykolen, wie Polyoxyäthylen- und Polyoxypropylenglykole mit Molekulargewichten von 200 bis 5000, Triolen, wie Glycerin, anderen Alkantriolen und Polyoxyäthylen- und Polyoxypropylentriolen mit Molekulargewichten von 400 bis 4000, hydroxylgruppenhaltigen Reaktionsprodukten aus Epoxidharzen mit einem Material mit Gruppen, die mit Epoxidgruppen zu reagieren vermögen, wie Carbonsäure-, Carbonsäureanhydrid-, phenolische Hydroxyl-, primäre oder sekundäre Amino- und Thiolgruppen, Pentaerythrit und hydroxylgruppenhaltigen Polymeren von Hydroxylalkylacrylaten und -methacrylaten und Copolymeren aus Styrol und Allylalkohol, und aliphatischen, cycloaliphatischen und aromatischen Isocyanaten erwähnt werden. Geeignete Isocyanate sind z.B. Hexamethylendiisocyanat, Trimethylhexamethylendiisocyanat, Phenylendiisocyanat, Toluylendiisocyanat, Diphenylmethandiisocyanat, Dicyclohexylmethandiisocyanat, Naphthylendiisiocyanate und Präpolymere mit Isocyanat-Endgruppen. Als Präpolymere mit Isocyanat-Endgruppen eignen sich z.B. Reaktionsprodukte aus einem Polyol, Polyamin oder einer Polycarbonsäure und einem aliphatischen, cycloaliphatischen oder aromatischen Diisocyanat. Bevorzugte derartige Präpolymere sind Reaktionsprodukte aus einem Polyol, besonders einem Polyesterpolyol, Polyätherpolyol, Acrylatpolyol oder Polycaprolacton mit einem Molekulargewicht im Bereich von 300—8000, und Hexamethylen-1,6-diisocyanat, Toluylendiisocyanat oder Isophorondiisocyanat. Geeignete Präpolymere mit Isocyanat-Endgruppen sind im Handel erhältlich; einige davon sind z.B. in der U.S. Patentschrift Nr. 4,173,682 beschrieben. Solche Präpolymere mit Isocyanat-Endgruppen können auch ohne Zusatz eines Polyols mit Ammoniak oder Aminen polymerisiert werden, wie es z.B. in der britischen Patentanmeldung Nr. 2,093,049 beschrieben ist.

Als Polyen-Polythiol-Gemische können z.B. solche der in der britischen patentschrift Nr. 1,293,722 beschriebenen Art verwendet werden. Die Polyene weisen im allgemeinen ein Molekulargewicht von 50 bis 20000 auf und enthalten zwei oder mehr äthylenische oder äthynylische, zur Polymerisation in Gegenwart von freien Radikalbildnern befähigte Bindungen. Bevorzugt als Polyene sind u.a. Reaktionsprodukte aus 1 Mol Toluylendiisocyanat mit 2 Mol eines Dialkenyläthers von Trimethylolpropan, Reaktionsprodukte aus 1 Mol eines polymeren Diisocyanats mit 2 Mol Allylalkohol, Reaktionsprodukte aus 1 Mol Polyäthylenglykol mit 2 Mol Toluylen-2,4-diisocyanat und 2 Mol Allylalkohol, Polyisopren, Polybutadien und andere ungesättigte Polymere, bei denen sich die ungesättigte Bindung vornehmlich in der Hauptkette befindet. Verbindungen mit reaktiven ungesättigten C-C-Bindungen in Konjugation mit benachbarten ungesättigten Gruppierungen, wie Polyäthylenätherglykoldiacrylat mit einem Molekulargewicht von etwa 750, Polytetramethylenätherglykoldimethacrylat mit einem Molekulargewicht von etwa 1175, die Triacrylate des Reaktionsproduktes aus Trimethylolpropan mit 20 Mol Aethylenoxid, sowie Reaktionsprodukte aus Polyepoxiden mit Aminen, Alkoholen, Thioalkoholen oder Säuren mit aliphatisch ungesättigten Bindungen, wie z.B. die Reaktionsprodukte von Bisphenol-A-Diglycidyläther mit Allylamin oder Diallylamin. Besonders bevorzugte Polyene sind durch zwei oder mehr Allyl- oder Methallylgruppen substituierte Phenole und vor allem Bisphenole.

Geeignete Polythiole weisen im allgemeinen ein Molekulargewicht von 50—20000, besonders 100—10000 auf. Ester der Thioglykol-, α-Mercaptopropion- und β-Mercaptopropionsäure mit Glykolen, Triolen, Tetraolen, Pentaolen oder Hexolen sind bevorzugt. Als spezifische Beispiele bevorzugter Polythiole seien erwähnt: Aethylenglykolbis(thioglykolat), Aethylenglykol-bis(β-mercaptopropionat), Trimethylolpropan-tris(β-mercaptopropionat), Pentaerythrit-tetrakis(β-mercaptopropionat) und Tris(hydroxyäthyl)isocyanurat-tris(β-mercaptopropionat). Geeignete polyen-Polythiol-Gemische sind ferner in der britischen Patentschrift Nr. 1,293,722 beschrieben.

Als Epoxidharze verwendet man im erfindungsgemässen Verfahren bevorzugt solche, die mindestens zwei direkt an ein O-, N- oder S-Atom gebundene Gruppen der Formel III

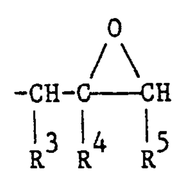 (III)

aufweisen, worin entweder $R^3$ und $R^5$ je ein Wasserstoffatom und $R^4$ ein Wasserstoffatom oder eine Methylgruppe bedeuten oder $R^3$ und $R^5$ zusammen $-CH_2CH_2-$ und $R^4$ ein Wasserstoffatom darstellen.

Als Beispiele solcher Harze seien erwähnt: Polyglycidyl- und Poly(β-methylglycidyl)ester von aliphatischen und aromatischen Polycarbonsäuren, Polyglycidyl- und Poly(β-methylglycidyl)äther von Verbindungen mit mindestens zwei freien alkoholischen oder phenolischen Hydroxylgruppen. Es können auch Poly(N-glycidyl)derivate von Aminen und Poly(S-glycidyl)verbindungen verwendet werden. Spezifische bevorzugte Epoxidharze sind Polyglycidyläther von 2,2-Bis(4-hydroxyphenyl)propan, Bis(4-hydroxyphenyl)methan oder Novolake aus Formaldehyd und Phenol oder Phenolen, die im Ring durch ein Chloratom oder eine Alkylgruppe mit 1—9 C-Atomen substituiert sind, mit einem Epoxidgehalt von mindestens 0,5 Aequivalent/kg, Bis(4-diglycidylaminophenyl)methan und p-(Diglycidylamino)phenylglycidyläther.

Es können auch Epoxidharze verwendet werden, in denen einige oder alle Epoxidgruppen nicht endständig sind, wie z.B. Vinylcyclohexendioxid, Limonendioxid, Dicyclopentadiendioxid, 4-Oxatetracyclo-[$6.2.1.0^{2,7}.0.^{3,5}$]undec-9-yl-glycidyläther, 1,2-Bis(4-oxatetracyclo[$6.2.1.0^{2,7}.0.^{3,5}$]undec-9-yloxy)äthan, 3,4-Epoxycyclohexylmethyl-3',4'-epoxycyclohexancarboxylat und dessen 6,6'-Dimethylderivat, Aethylenglykol-bis(3,4-epoxycyclohexancarboxylat), 3-(3,4-Epoxycyclohexyl)-8,9-epoxy-2,4-dioxaspiro[5.5]undecan sowie epoxidierte Butadiene oder Copolymere von Butadienen mit äthylenischen Verbindungen, wie Styrol und Vinylacetat.

Epoxidharz/Thiol-Mischungen, die im erfindungsgemässen Verfahren eingesetzt werden können, sind bevorzugt Gemische aus den oben beschriebenen Epoxidharzen und Polythiolen. Geeignete Amine zur Verwendung in Epoxidharz/Amin-Gemischen sind im allgemeinen tertiär und können aliphatisch, alicyclisch, ungesättigt heterocyclisch oder araliphatisch sein, z.B. N,N,N',N'-Tetramethyläthylen-, -propylenoder -butylen-diamine, Trialkylmonoamine, wie Triäthylamin, Trialkanolamine, wie Triäthanolamin, N,N'-Dimethylpiperazin, Triäthylendiamin, Hexamethylentetramin, Pyridin, Chinolin, Benzyldimethylamin und 2,4,6-Tris(dimethylaminomethyl)phenol.

Als phenolische Harze können im erfindungsgemässen Verfahren z.B. Resole aus Phenolen, besonders Phenol selbst, oder einem Alkylphenol mit 1-9 C-Atomen in der Alkylgruppe, und einem Aldehyd, im allgemeinen Formaldehyd, verwendet werden.

Beispiele von Acrylat- und Methacrylat-Monomeren, die mit Wasserstoffperoxid oder einem Hydroperoxid gemischt und in Gegenwart von Schwefeldioxid vernetzt werden können, sind Acryl- und Methacrylsäure, Alkylacrylate, wie Methyl- und Aethylacrylat, Alkylendiolacrylate, wie Aethylen- und Propylenglykoldiacrylate, 1,1,1-Trimethylolpropantriacrylat, Polypropylenglykoldiacrylat, Allylacrylat und die entsprechenden Methacrylate. Geeignete Hydroperoxide sind z.B. tert-Butylhydroperoxid, Cumolhydroperoxid und 2,4-Dimethyl-2,4-hexandihydroperoxid.

Als lichtvernetzbare Reste kommen sowohl solche in Betracht, bei denen die Vernetzung durch direkte Aktivierung der lichtempfindlichen Gruppen mittels Bestrahlung erfolgt, als auch solche, bei welchen durch die Bestrahlung ein geeignetes Initiatormolekül angeregt wird, welches dann die photopolymerisierbaren Gruppen aktiviert.

Materialien mit lichtempfindlichen Gruppen sind bekannt und umfassen z.B. solche mit mindestens zwei, bevorzugt 3 oder mehr Gruppen ausgewählt aus Azido-, Cumarin-, Stilben-, Maleinimid-, Pyridinon-, Chalkon-, Propenon-, Pentadienon-, Anthracen- und Acrylsäureestergruppen, die in der 3-Stellung durch eine äthylenisch ungesättigte Gruppe oder eine aromatische Gruppe in Konjugation mit der äthylenischen Doppelbindung der Acrylgruppe substituiert sind.

Als Materialien, bei denen die Photovernetzung durch Aktivierung eines Photoinitiators erfolgt, der dann seinerseits polymerisierbare Gruppen aktiviert, können z.B. verwendet werden: Epoxidharze, phenolische Harze, Harnstoff-Formaldehyd-Harze, cyclische Aether, cyclische Ester, cyclische Sulfide, cyclische Amine und cyclische Organosiliziumverbindungen in Kombination mit einem strahlungsempfindlichen aromatischen Oniumsalz, wie z.B. Diazonium-, Sulfonium-, Jodonium- und Sulfoxoniumsalze, oder einem strahlungsempfindlichen aromatischen Jodosylsalz, sowie Ester und Teilester von Acryl- oder Methacrylsäure mit einwertigen aliphatischen Alkoholen, Glykolen und höherwertigen Polyolen, oder mit Verbindungen, die eine oder mehr Glycidylgruppen enthalten, ferner Ester, erhalten durch Reaktion eines Polyepoxids mit einem Addukt aus einem Hydroxyalkylacrylat oder -methacrylat und einem gesättigten oder ungesättigten Polycarbonsäureanhydrid.

Beispiele von geeigneten Aziden sind solche mit mindestens zwei Gruppen der Formel IV

$$N_3Ar- \qquad (IV)$$

worin Ar einen einkernigen oder zweikernigen zweiwertigen aromatischen Rest mit insgesamt 6 und höchstens 14 C-Atomen, besonders eine Phenylen- oder Naphthylengruppe, bedeutet.

Beispiele von geeigneten Cumarinen sind solche mit Gruppen der Formel V

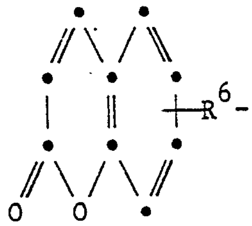

(V),

worin $R^6$ —O—, —COO—, —$SO_2$— oder —$SO_2O$— darstellt.

Als Stilbene eignen sich z.B. solche mit Gruppen der Formel VI

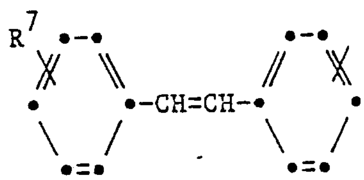

(VI),

worin $R^7$ der insgesamt bis zu 8 C-Atome enthaltende Rest eines 5- oder 6-gliedrigen N-haltigen heterocyclischen Ringes ist, der mit einem Benzol- oder Naphthalinkern kondensiert und über ein zu einem Ring-N-Atom benachbartes C-Atom des heterocyclishen Ringes an den genannten Benzolkern gebunden ist, wie z.B. Benzimidazolyl-, Benzoxazolyl-, Benztriazolyl-, Benzthiazolyl- oder Naphthotriazolylreste.

Beispiele von Verbindungen mit Maleinimidgruppen sind solche mit Gruppen der Formel VII

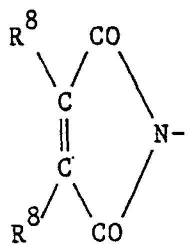

(VII),

worin die $R^8$ Alkyl mit 1-4 C-Atomen, ein Chloratom oder eine Phenylgruppe und besonders eine Methylgruppe bedeuten.

Als Verbindungen mit Pyridinongruppen eignen sich z.B. solche mit Gruppen der Formel VIII

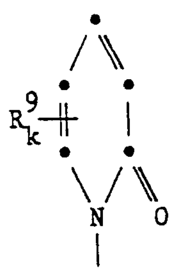

(VIII),

worin $R^9$ einen aliphatischen oder cycloaliphatischen Rest mit bis zu 8 C-Atomen und k 0 oder eine ganze Zahl von 1—4 bedeuten.

Als Verbindungen mit Chalkon-, Propenon- und Pentadienongruppen kommen solche mit Gruppen der Formel IX oder X

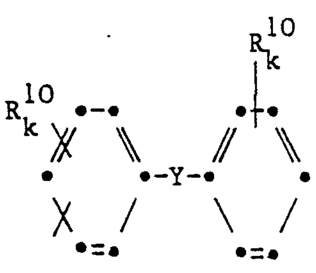

oder

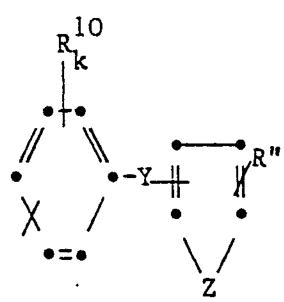

(IX) (X)

in Betracht, worin die $R^{10}$ ein Halogenatom, eine Alkyl-, Cycloalkyl-, Alkenyl-, Cycloalkenyl-, Alkoxy-, Cycloalkoxy-, Alkenyloxy-, Cycloalkenyloxy-, Alkoxycarbonyl-, Cycloalkoxycarbonyl-, Alkenyloxycarbonyl- oder Cycloalkenyloxycarbonylgruppe mit je bis zu 9 C-Atomen, eine Nitrogruppe, eine Carbonsäure-, Sulfonsäure- oder Phosphorsäuregruppe in Salzform bedeuten,

k die oben angegebene Bedeutung hat.

$R^{11}$ eine Bindung oder ein Wasserstoffatom,

Y eine Gruppe der Formel XI, XII oder XIII

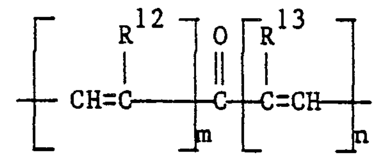 ,

(XI) ,

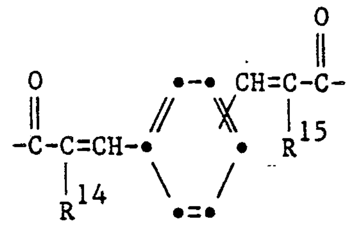

(XII) ,

oder

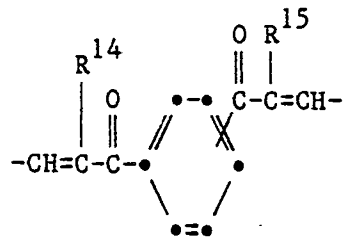

(XIII),

$R^{12}$ und $R^{13}$ unabhängig voneinander ein Wasserstoffatom, eine Alkylgruppe mit z.B. 1—4 C-Atomen oder eine Arylgruppe, besonders eine einkernige Arylgruppe, wie die Phenylgruppe, oder $R^{12}$ und $R^{13}$ zusammen eine Polymethylenkette mit 2—4 Methylengruppen, $R^{14}$ und $R^{15}$ unabhängig voneinander ein Wasserstoffatom, eine Alkylgruppe mit z.B. 1—4 C-Atomen oder eine Arylgruppe, vorzugsweise eine einkernige Gruppe, wie die Phenylgruppe, m und n unabhängig voneinander Null, 1 oder 2, aber nicht beide Null, und

Z ein Sauerstoff- oder Schwefelatom bedeuten.

Geeignete Anthracene sind solche mit Anthrylgruppen, wie die 1—, 2-oder 9-Anthrylgruppe, die unsubstituiert oder durch ein oder zwei Brom- oder Chloratome, eine oder zwei Methyl- oder Nitrogruppen substituiert sein können.

Als 3-substituierte Acrylate eignen sich z.B. solche der Formel XIV

$$R^{16}\text{—CH} = \text{C}(R^{17})\text{COO—} \qquad \text{(XIV)}$$

worin $R^{16}$ eine aliphatische oder einkernige aromatische, araliphatische oder heterocyclische Gruppe darstellt, die — wie schon erwähnt äthylenisch ungesättigt ist oder in Konjugation mit der äthylenischen Doppelbindung aromatischen Charakter hat, wie z.B. die Phenyl-, 2-Furyl-, 2- oder 3-Pyridyl-, Prop-2-enyl- oder Styrylgruppe, und

$R^{17}$ ein Wasserstoff-, Chlor- oder Bromatom oder eine Alkylgruppe mit 1—4 C-Atomen darstellt.

Als Beispiele solcher Verbindungen seien die Disorbinsäureester von Poly(oxyalkylen)glykolen, Polyvinylzimtsäureester und Reaktionsprodukte aus Epoxidharzen und Zimtsäure genannt.

Oniumsalze, die in Kombination mit Epoxidharzen oder anderen kationisch polymerisierbaren Substanzen photopolymerisierbare Mischungen ergeben, sind in den U.S. Patentschriften Nr. 4,058,400 und 4,058,401 beschrieben. Sulfoxoniumsalze, die für denselben Zweck eingesetzt werden können, sind in den U.S. Patentschriften Nr. 4,299,938, 4,339,567 und 4,383,025 beschrieben.

Aromatische Jodosylsalze, die in Kombination mit kationisch polymerisierbaren Substanzen photopolymerisierbare Gemische ergeben, sind z.B. solche der Formel

$$[(Ar^1)(Ar^2)\overset{+}{I}O]_t X^{t-},$$

worin $Ar^1$ und $Ar^2$ unabhängig voneinander einen einwertigen aromatischen Rest mit 4—25 C-Atomen,

$X^{t-}$ ein t-wertiges Anion einer Protonensäure und

t 1, 2 oder 3 bedeuten.

$Ar^1$ und $Ar^2$ sind vorzugsweise je Phenyl, wobei die Phenylringe durch eine Alkylgruppe mit 1—4 C-Atomen, ein Halogenatom oder eine Nitrogruppe substituiert sein können.

Die Anionen $X^{t-}$ werden so gewählt, dass eine wirksame Vernetzung eintritt. Aufeinander abgestimmte kationisch polymerisierbare Materialien und geeignete Anionen können vom Fachmann auf dem Gebiet der Vernetzung oder Polymerisation kationisch polymerisierbarer Stoffgemische leicht ermittelt werden. Salze mit Anionen, die sich von organischen Carbonsäuren, organischen Sulfonsäuren und anorganischen Säuren ableiten, besonders Acetate, Trifluoracetate, Methansulfonate, Benzolsulfonate, p-Toluolsulfonate, Trifluormethansulfonate, Fluoride, Chloride, Bromide, Jodate, Perchlorate, Nitrate, Sulfate, Hydrogensulfate, Phosphate oder Hydrogenphosphate eignen sich z.B. zum Vernetzen von Phenoplasten, wie Phenol-Formaldehydharzen, und Aminoplasten, wie Harnstoff-Formaldehydharzen. Salze mit einem Pentafluorhydroxoantimonat-Anion oder einem Metallhalogenid- oder Metalloidhalogenid-Anion der Formel $MQ_w^-$, worin

M das Atom eines Metalls oder Metalloids,

Q ein Halogenatom und

w eine ganze Zahl von 4 bis 6 bedeuten, wobei w um eines grösser ist als die Wertigkeit von M,

eignen sich zum Vernetzen von Epoxidharzen und Episulfidharzen.

Bevorzugte Anionen $MQ_w^-$ sind das Hexafluorantimonat-, Hexachlorantimonat-, Hexafluorarsenat-, Tetrachlorferrat-, Hexachlorstannat-, Tetrafluorborat- oder Hexafluorphosphat-Anion, wobei die beiden letztgenannten besonders bevorzugt sind.

Als Ester oder Teilester von Acryl- und Methacrylsäure, die als lichtvernetzbare Reste im erfindungsgemässen Verfahren verwendet werden können, kommen z.B. solche mit mindestens einer Gruppe der Formel XV

$$H_2C=C(R^{18})-COO- \qquad (XV)$$

in Betracht, worin $R^{18}$ ein Wasserstoffatom oder eine Methylgruppe darstellt.

Bevorzugt sind Ester von Glykolen, wie Aethylenglykol, Triäthylenglykol und Tetraäthylenglykol, und Ester, die durch Umsetzung von Acryl- oder Methacrylsäure mit Mono- oder Polyglycidyläthern von ein- oder mehrwertigen Alkoholen oder Phenolen oder einem N-Glycidylhydantoin erhalten werden. Weitere geeignete Ester sind Umsetzungsprodukte aus einem Addukt eines Hydroxyalkylacrylats oder -methacrylats und einem Anhydrid, besonders Bernsteinsäure-, Maleinsäure- oder Phthalsäureanhydrid, und einem Epoxidharz.

Typische Beispiele solcher Ester sind: 1,4-Bis(2-hydroxy-3-acryloyloxypropoxy)butan, Poly(2-hydroxy-3-acryloyloxypropyl)äther von Phenol-Formaldehydnovolaken, 2,2-Bis[(4-(2-hydroxy-3-(2-acryloyloxyäthoxy)-succinyloxypropoxy)]-phenyl)propan, 1-(2-Hydroxy-3-acryloyloxypropoxy)butan, -octan und -decan, Bis(2-hydroxy-3-acryloyloxypropyl)adipat, 2-Hydroxy-3-acryloyloxypropyl-propionat und 3-Phenoxy-2-hydroxypropyl-acrylat sowie die entsprechenden Methacrylate.

Wie oben erwähnt, können die polymerisierbaren Gruppen und die lichtvernetzbaren Gruppen in demselben Molekül vorliegen. So könenn z.B. Epoxidharze mit photohärtbaren Gruppen in den oben beschriebenen Ausführungsformen, die den Einsatz von Epoxiden vorsehen, verwendet werden; hydroxylsubstituierte Verbindungen mit photohärtbaren Gruppen eignen sich für Ausführungsformen, bei denen ein Gemisch aus einem Polyol und einem Isocyanat verwendet wird. Geeignete doppelfunktionelle Substanzen können hergestellt werden, indem man eine oder mehrere äthylenisch ungesättigte Gruppen, wie Acrylsäure-, Methacrylsäure- oder Zimtsäureestergruppen oder Chalkongruppen, in eine Verbindung mit einer oder mehreren polymerisierbaren Gruppen, wie Epoxidgruppen, oder einer oder mehreren Gruppen, die mit einer anderen reaktiven Gruppe auf einem anderen Molekül zu einem Polymer reagieren, wie Mercapto- und Hydroxylgruppen, einführt. Die Einführung von äthylenisch ungesättigten Gruppen kann mittels Esterbildung erfolgen, z.B. unter Verwendung von Acryl-, Methacrylsäure- oder Zimtsäuregruppen oder Chalkongruppen enthaltenden Carbonsäuren und einer OH- oder SH-Gruppen enthaltenden Verbindung oder einem Epoxid in derartigen Verhältnissen, dass das Produkt mindestens eine nicht reagierte OH—, Mercapto- oder Epoxidgruppe enthält.

Werden Acrylsäure, Methacrylsäure oder Zimtsäure mit Epoxidharzen umgesetzt, so können alle Epoxidgruppen des Harzes umgesetzt werden, weil dabei die bei der Oeffnung des Epoxidringes entstehenden OH-Gruppen die für das erfindungsgemässe Verfahren erforderliche reaktive OH-Funktionalität liefern.

Weitere geeignete doppelfunktionelle Substanzen sind z.B. hydroxysubstituierte Chalkone, hydroxyphenyl-substituierte Propenone und Pentadienone, hydroxy-substituierte Maleinimide und hydroxy-substituierte Pyridinone. Besonders bevorzugte doppelfunktionelle Substanzen sind Glycidylacrylat, Glycidylmethacrylat, Acrylat-, Methacrylat- oder Zimtsäureestergruppen enthaltende Aether und Ester von phenolischen Resolen und Epoxiden, einschliesslich voll umgesetzter Produkte aus Acrylsäure. Methacrylsäure und Zimtsäure und Epoxidharzen, wie Polyglycidyläther von mehrwertigen Alkoholen und Phenolen einschliesslich Phenol-Novolakharzen, sowie teilweise Reaktionsprodukte aus diesen Komponenten, wie 2-(4-Glycidyloxyphenyl)-2-(4-(3-acryloyloxy-2-hydroxypropoxy)phenyl)propan, 2-(4-Glycidyloxyphenyl)-2-[4-(2-hydroxy-3-methacryloyloxy)propoxy)phenyl]propan, 1-Glycidyloxy-4-(3-acryloyloxy-2-hydroxypropyloxy)butan und 1-Glycidyloxy-4-(2-hydroxy-3-methacryloyloxypropyloxy)butan.

Um mit den neuen Verfahren möglichst gute Bilder zu erzeugen, werden die Polymerisation und die Lichtvernetzung bevorzugt mit verschiedenen chemischen Vorgängen bewirkt. Wird zum Beispiel die erste Stufe durch Behandlung eines phenolischen Harzes mit sauren Dämpfen durchgeführt, so sollte in der zweiten Stufe vorzugsweise keine Umsetzung eines phenolischen Harzes mit einer infolge der Bestrahlung eines Initiatormoleküls freigesetzten Säure erfolgen.

Die Art und Weise, wie das flüssige Stoffgemisch mit dem gasförmigen Polymerisationsmittel in Kontakt gebracht wird, ist nicht kritisch.

Im allgemeinen wird das mit dem flüssigen Stoffgemisch beschichtete Substrat in einer Kammer angeordnet, worauf man die Luft in der Kammer durch gasförmiges polymerisationsmittel ersetzt oder sie damit sättigt. Wird als gasförmiges Polymerisationsmittel Luftfeuchtigkeit benützt, so kann es ausreichen, wenn man das beschichtete Substrat bei Umgebungstemperatur bis zum Verfestigen der Luftfeuchtigkeit aussetzt.

Die Lichtvernetzung kann mittels Bestrahlung in Gegenwart eines geeigneten Katalysators durchgeführt werden. Wie die lichtvernetzbaren Verbindungen, gehören die Katalysatoren zwei Hauptklassen an:

(i) solche, die bei Bestrahlung einen angeregten Zustand ergeben, der zur Bildung freier Radikale führt, die ihrerseits die Vernetzung des Monomeren initiieren (Photoinitiatoren) und (ii) solche, die bei Bestrahlung einen angeregten Zustand ergeben, der seine Anregungsenergie auf ein Monomermolekül überträgt, wobei ein angeregtes Monomermolekül entsteht, das dann mit einem nicht angeregten Monomermolekül vernetzt (Photosensibilisatoren).

Zu der ersten Klasse gehören organische Peroxide und Hydroperoxide, α-halogen-substituierte Acetophenone, Benzoin und dessen Alkyläther, α-Methylbenzoin, Benzophenone, O-Alkoxycarbonyl-Derivate eines Benziloxims oder eines 1-Phenylpropan-1,2-dionoxims, Benzilketale, z.B. das Benzildimethylketal, substituierte Thioxanthone, z.B. 2-Chlorthioxanthon und 2-Isopropylthioxanthon, Anthrachinone und Gemische aus Phenothiazin-Farbstoffen oder Chinoxalinen mit Elektronendonoren. Diese Initiatoren werden für ungesättigte Ester, vor allem Acrylate und Methacrylate, angewendet.

Zu der zweiten Klasse gehören 5-Nitroacenaphthene, 4-Nitroanilin, 2,4,7-Trinitro-9-fluorenon, 3-Methyl-1,3-diaza-1,9-benzanthron und Bis(dialkylamino)benzophenone, besonders Michler's Keton, d.h. 4,4'-Bis(dimethylamino)-benzophenon.

Geeignete Trägermaterialien, auf welchen die flüssigen Stoffgemische erfindungsgemäss polymerisiert und vernetzt werden können, sind z.B. Metalle, besonders Kupfer und Aluminium, faserverstärkte Verbundwerkstoffe, die gegebenenfalls mit einem Metall überzogen sind, und Silicon-Wafer.

In der dritten Stufe des erfindungsgemässen Verfahrens wir vorzugsweise aktinisches Licht mit einer Wellenlänge von 200—600 nm eingesetzt. Geeignete Lichtquellen für aktinisches Licht sind z.B. Kohlelichtbögen, Quecksilberdampfbögen, fluoreszierende Lampen mit ultraviolettes Licht ausstrahlenden Phosphoren, Argon- und Xenonglühlampen, Wolframlampen und photographische Flutlichtlampen. Quecksilberdampflampen, besonders Sonnenlampen, fluoreszierende Sonnenlampen und Metallhalogenidlampen sind besonders bevorzugt. Die für die Belichtung benötigte Zeit hängt von verschiedenen Faktoren ab, z.B. den spezifisch eingesetzten Verbindungen, dem Anteil dieser Verbindungen im Stoffgemisch, der Art der Lichtquelle und deren Abstand von dem Stoffgemisch. Die geeigneten Belichtungszeiten können von dem Fachmann auf dem Gebiet der Photovernetzung leicht ermittelt werden.

Nach der Bestrahlung werden die nicht belichteten Stellen mit Hilfe eines Lösungsmittels ausgewaschen, z.B. Cyclohexanon, 2-Aethoxyäthanol, Toluol, Aceton und Gemischen davon sowie wässrigen Säuren und Basen, wie verdünnte Salzsäure, wässriges Natriumcarbonat oder Natriumhydroxid. Die erfindungsgemässen Stoffgemische können somit zur Herstellung von Druckplatten und gedruckten Schaltungen verwendet werden. Die Verfahren zur Herstellung von Druckplatten und gedruckten Schaltungen aus lichtvernetzbaren Stoffgemischen sind allgemein bekannt.

Die Erfindung wird in den folgenden Beispielen erläutert. Teile und Prozente sind Gewichtsteile bzw. Gewichtsprozente, sofern nichts anderes angegeben ist.

Die in den Beispielen verwendeten Harze werden wie folgt hergestellt:

Harz I

100 g eines Epoxidharzes auf der Basis von 2,2-Bis(4-hydroxyphenyl)propan mit einem Epoxidgehalt von 1,5 Aequivalenten/kg und 0,1 g 2,6-Di-tert-butyl-4-methylphenol werden bis zur Schmelze erhitzt, zusammen gerührt und auf 130°C erhitzt. Zu diesem Gemisch gibt man im Verlaufe von 30 Minuten langsam ein Gemisch aus 10,7 g Acrylsäure, 0,05 g Chrom(III)tris-octanoat und 0,2 g 2,6-Di-tert-butyl-4-methylphenol. Nach Beendigung der Zugabe wird das Gemisch während 2 Stunden bei 130°C gerührt und abgekühlt. Das erhaltene Produkt hat einen Epoxidgehalt von 0,07 Aequiv./kg.

Harz II

100 g 2,2-Bis(4-glycidyloxyphenyl)propan mit einem Epoxidgehalt von 5,1 Aequiv./kg und 0,1 g 2,6-Di-tert-butyl-4-methylphenol werden zusammen gerührt und auf 100°C erhitzt. Das Gemisch wird im Verlaufe von 1 1/2 Stunden langsam mit einem Gemisch aus 19,l g Acrylsäure, 0,05 g Chrom(III)tris-octanoat und 0,2 g 2,6-Di-tert-butyl-4-methylphenol versetzt. Nach Beendigung der Zugabe wird das Gemisch während

weiteren 7 Stunden bei 100°C gerührt und abgekühlt. Das erhaltene Produkt hat einen vernachlässigbaren Epoxidgehalt.

Harz III

Ein Gemisch aus 100 Teilen eines Epoxy-Novolakharzes mit einem Epoxidgehalt von 5,61 Aequiv./kg (ein Polyglycidyläther aus einem Phenol-Formaldehyd-Novolak mit einem durchschnittlichen Molekulargewicht von 420),0,2 Teile 2,6-Di-tert-kresol und 0,1 Teil Chrom(III)-tris-octanoat wird auf 120°C erhitzt und während einer Stunde mit 83 Teilen Zimtsäure versetzt. Es wird während weiteren 3 1/2 Stunden auf 120°C erhitzt, worauf man das Gemisch abkühlen lässt. Das erhaltene Produkt wird bei Raumtemperatur fest und hat einen vernachlässigbaren Epoxidgehalt.

Harz IV

Harz IV ist ein 2,2-Bis(4-glycidyloxyphenyl)propan mit einem Epoxidgehalt von 5,1 Aequiv./kg.

Harz V

Harz V ist 1,4-Butandioldiglycidyläther.

Harz VI

Harz VI ist 3,4-Epoxycyclohexylmethyl-3',4'-epoxycyclohexancarboxylat.

Harz VII

Es wird ein Gemisch aus 80% Phenol (20,84 Teile), 38,3% Formalinlösung (22,22 Teile) und 1,94 Teilen Zinkacetat hergestellt. Das Gemisch wird 2 1/2 Stunden unter Rückfluss erhitzt. Anschliessend wird die Lösung abgekühlt und die wässrige Phase wird entfernt, wobei 22,35 Teile eines phenolischen Resols erhalten werden. Dieses wird zuerst mit gesättigter NaOH-Lösung und dann zweimal mit Wasser gewaschen. Das erhaltene Resol hat eine Viskosität von 3,15 Pas bei 25°C.

20 Teile dieses Resols werden mit 0,04 Teilen Tetramethylammoniumchlorid und 0,055 Teilen 2,6-Di-tert-butyl-4-methylphenol vermischt und auf 80°C erhitzt. Im Verlaufe einer Stunde werden 7,37 Teile Glycidylmethacrylat zugegeben. Nach Beendigung der Zugabe wird 10 3/4 Stunden weiter erhitzt. Das erhaltene Produkt, ein 3-Methacryloyl-2-hydroxypropyläther eines phenolischen Resols, hat eine Viskosität von 14,75 Pa s bei 25°C und einen vernachlässigbaren Epoxidgehalt.

Harz VIII

5 Teile 1,4-Butandioldiglycidyläther und 0,02 Teile Tetramethylammoniumchlorid werden zusammen auf 120°C erhitzt und dann im Verlaufe von 15 Minuten mit 7,42 Teilen 1,5-Di(4-hydroxyphenyl)penta-1,4-dien-3-on versetzt. Das Gemisch wird während weiteren 2 1/2 Stunden bei der gleichen Temperatur gehalten, wobei der Epoxidgehalt des Gemisches auf einen vernachlässigbaren Wert sinkt. Es werden 1,06 Teile Glutarsäureanhydrid zugegeben, und das Gemisch wird noch 2 Stunden auf 120°C erhitzt, Das erhaltene produkt, ein lichtvernetzbares Harz mit sauren Gruppen, hat ein Infrarot-Spektrum, das keine Anhydridgruppen mehr zeigt.

Harz IX

Harz IX ist das 4,4'-Di-Phenylmethan-diisocyanat.

Harz X

Harz X ist ein im Handel erhältliches Gemisch aus Trimethylhexamethylen-diisocyanaten.

Harz XI

Harz XI ist das 1,1,1-Trimethylolpropan-trisacrylat.

Harz XII

Harz XII ist ein im Handel erhältliches Präpolymer mit Isocyanat-Endgruppen, erhalten druch Umsetzung eines Polytetramethylenglykols mit einem durchschnittlichen Molekulargewicht von etwa 500 mit Toluylen-2,4-diisocyanat; Gehalt an verfügbaren Isocyanatgruppen = 9,45%.

## Beispiel 1

3 Teile Harz I werden in 2 Teilen Methyl-2-cyanacrylat gelöst, wobei eine klare Lösung entsteht. Durch Zugabe von 0,05 Teilen Benzildimethylketal erhält man eine Lösung, die unter trockenen Bedingungen lagerstabil ist, Mit der Lösung wird ein kupferkaschiertes Laminat beschichtet (Schichtdicke 20 µm) und während 30 Sekunden in einer Kammer mit gasförmigem Ammoniak behandelt, Die Beschichtung verfestigt sich zu einer klebfreien Schicht. Diese Schicht wird anschliessend während 20 Sekunden in einem Abstand von 75 cm durch ein Negativ mit einer 5000 Watt Metallhalogenidlampe bestrahlt. Nach dem Entwickeln in Aceton erhält man ein Bild.

Beispiel 2

2 Teile Harz werden in 1 Teil Aethyl-2-cyanacrylat gelöst und mit 0,09 Teilen Benzildimethylketal versetzt. Mit der erhaltenen klaren Lösung wird ein kupferkaschiertes Laminat beschichtet (Schichtdicke 20 µm), Das beschichtete Laminat wird in einer Kammer während 30 Sekunden mit gasförmigem Ammoniak behandelt, wobei die Beschichtung klebfrei wird, Die verfestigte Beschichtung wird während 10 Minuten in einem Abstand von 20 cm durch ein Negativ mit einer 3 W/cm Mitteldruckquecksilberlampe bestrahlt. Nach dem Entwickeln mit einem 9:1-Volumen-Gemisch aus Toluol und Aceton erhält man ein gutes Bild.

Beispiel 3

Beispiel 2 wird wiederholt, wobei in diesem Fall die Beschichtung 45—50 µm dick ist. Nach 30 Sekunden Behandlung in gasförmigem Ammoniak ist die Beschichtung klebfrei. Sie wird während 3 Minuten in einem Abstand von 20 cm durch ein Negativ mit einer 32 W/cm Mitteldruckquecksilberlampe bestrahlt. Nach dem Entwickeln mit einem Gemisch aus Toluol und Aceton (9:1-Volumenverhältnis) erhält man ein gutes klares Bild.

Beispiel 4

Beispiel 2 wird wiederholt, wobei die Beschichtung in diesem Fall 10—15 µm dick ist. Anstatt mit gasförmigem Ammoniak wird die Beschichtung bei 21°C in einer Luft mit einer Feuchtigkeit von 80% enthaltenden Kammer behandelt. Nach 3 Minuten ist die Beschichtung klebfrei, Anschliessend wird die Beschichtung während 10 Minuten in einem Abstand von 75 cm durch ein Negativ mit einer 5000 Watt Metallhalogenidlampe bestrahlt. Nach dem Entwickeln in Toluol erhält man ein gutes klares Bild.

Beispiel 5

1 Teil Harz III wird in 1 Teil Aethyl-2-cyanacrylat und 0,2 Teilen p-Toluolsulfonsäure gelöst und mit 0,1 Teil 4,4'-Bis(dimethylamino)benzophenon versetzt. Mit dieser Lösung wird ein kupferkaschiertes Laminat beschichtet (Schichtdicke 10 µm), und dieses wird in einer Kammer während 2 Minuten mit gasförmigem Ammoniak behandelt. Dabei wird der Film klebfrei. Die verfestigte Schicht wird während 5 Minuten in einem Abstand von 75 cm durch ein Negativ mit einer 5000 Watt Metallhalogenidlampe belichtet. Nach dem Entwickeln in einem Gemisch aus Xylol und Aceton (9:1-Volumenverhältnis) erhält man ein gutes Bild.

Beispiel 6

1 Teil Harz IV wird mit 1 Teil Aethyl-2-cyanacrylat, 0,2 Teilen Diphenyljodonium-hexafluorphosphat und 0,05 Teilen 2-Isopropylthioxanthon vermischt. Damit wird ein kupferkaschiertes Laminat beschichtet (Schichtdicke 10 µm). Die Beschichtung wird durch Behandeln mit gasförmigem Ammoniak während 10 Sekunden zu einem klebfreien Film verfestigt und während 40 Sekunden in einem Abstand von 75 cm durch ein Negativ mit einer 5000 Watt Metallhalogenidlampe belichtet. Nach dem Entwickeln in einem Gemisch aus Xylol und Aceton (9:1-Volumenverhältnis) erhält man ein gutes Bild.

Beispiel 7

Aus 10 Teilen Harz II, 5 Teilen Harz IV, 3 Teilen Harz V, 2 Teilen Harz VI und 0,1 Teil Benzildimethylketal wird eine Gemisch hergestellt. Mit diesem Gemisch wird ein kupferkaschiertes Laminat beschichtet (Schichtdicke 30 µm) und dann in einer mit einem Gemisch aus Bortrifluorid und Stickstoff gefüllten Kammer (Volumenverhältnis ca. 1:4) behandelt. Die Beschichtung wird innerhalb von 10 Sekunden klebfrei. Nach dem Behandeln während 10 Sekunden in einem Abstand von 75 cm durch ein Negativ mit einer 5000 Watt Metallhalogenidlampe und nach dem Entwickeln in einem Gemisch aus Toluol und Aceton (Volumenverhältnis 9:1) erhält man ein gutes Bild.

Beispiel 8

1 Teil Harz II wird mit 1 Teil Toluylen-2,4-diisocyanat und 0,01 Teilen Benzildimethylketal vermischt. Mit diesem Gemisch wird ein kupferkaschiertes Laminat beschichtet (Schichtdicke 20 µm) und in einer mit 10 Vol. % Triäthylamindampf in Stickstoff gefüllten Kammer behandelt. Innerhalb von 10 Sekunden wird die Beschichtung klebfrei. Nach dem Bestrahlen während 10 Sekunden in einem Abstand von 75 cm durch ein Negativ mit einer 5000 Watt Metallhalogenidlampe und Entwikeln in einem Gemisch aus Toluol und Aceton (Volumenverhältnis 9:1) erhält man ein gutes Bild.

Beispiel 9

10 Teile Harz VII werden mit 0,1 Teil Benzildimethylketal vermischt. Mit diesem Gemisch wird ein kupferkaschiertes Laminat beschichtet (Schichtdicke 20 µm). Das Laminat wird während 2 Minuten in einer mit 10 Vol. % HCl in Stickstoff gefüllten Kammer behandelt, wobei die Beschichtung klebfrei wird. Nach dem Bestrahlen während 10 Sekunden in einem Abstand von 75 cm durch ein Negativ mit einer 5000 Watt Metallhalogenidlampe und Entwickeln in Toluol erhält man ein gutes Bild.

Beispiel 10

10 Teile Harz VIII werden mit 20 Teilen Aethyl-2-cyanacrylat vermischt. Mit diesem Gemisch wird ein

kupferkaschiertes Laminat beschichtet (Schichtdicke 20 µm). Die Beschichtung wird bei 21°C während 10 Sekunden mit mit Wasserdampf gesättigtem Stickstoff behandelt, wobei die Beschichtung klebfrei wird. Nach dem Bestrahlen während 30 Sekunden in einem Abstand von 75 cm durch ein Negativ mit einer 5000 Watt Metallhalogenidlampe und dem Entwickeln in 2 %igem wässrigem Natriumhydroxid erhält man ein gutes Bild.

Beispiel 11

50 Teile Harz IX, 30 Teile Harz II, 20 Teile Harz XI und 3 Teile Benzildimethylketal werden vermischt. Mit dem Gemisch wird ein kupferkaschiertes Laminat beschichtet (Schichtdicke 20 µm) und dann in einer Kammer behandelt, die 10 Vol. % Triäthanolamindampf in Stickstoff enthält. Die Beschichtung wird innerhalb von 20 Minten klebfrei. Nach dem Bestrahlen während 30 Sekunden durch ein Negativ mit einer 5000 Watt Metallhalogenidlampe in einem Abstand von 75 cm und dem Entwickeln in einem 9:1-Volumengemisch aus Toluol und Aceton erhält man ein gutes Bild.

Beispiel 12

Beispiel 11 wird wiederholt, wobei die Behandlungskammer 10 Vol. % N,N-Dimethyläthanolamin in Stickstoff anstatt 10 Vol. % Triäthanolamin in Stickstoff enthält. Nach 2 Minuten ist die Beschichtung klebfrei. Nach dem Bestrahlen während 30 Sekunden in einem Abstand von 75 cm durch ein Negativ mit einer 5000 Watt Metallhalogenidlampe und dem Entwickeln in einem 9:1-Volumengemisch aus Toluol und Aceton erhält man ein gutes klares Bild.

Beispiel 13

Mit einem Gemisch aus 40 Teilen Harz X, 40 Teilen Harz II, 20 Teilen Harz XI und 3 Teilen Benzildimethylketal wird ein kupferkaschiertes Laminat beschichtet (Schichtdicke 20—25 µm). Dieses wird in eine Kammer gegeben, die mit einem Gemisch aus 10 Vol. % N,N-Dimethyläthanolamindampf in Stickstoff gefüllt ist. Nach 5 Minuten ist die Beshichtung klebfrei. Nach dem Bestrahlen durch ein Negativ mit einer 5000 Watt Metallhalogenidlampe in einem Abstand von 75 cm während 25 Sekunden und dem Entwickeln mit einem 9:1-Volumengemisch aus Toluol und Aceton erhält man ein klares Bild.

Beispiel 14

35 Teile Harz XII, 35 Teile Harz II, 30 Teile Harz X und 3 Teile Benzildimethylketal werden vermischt und dann auf ein kupferkaschiertes Laminat appliziert (Schichtdicke 6 µm). Die Beschichtung wird mit einem Gemisch aus 10 Vol. % Triäthylamindampf in Stickstoff während 3 Minuten behandelt, wobei eine klebfreie Oberfläche entsteht. Nach dem Bestrahlen durch ein Negativ während 1 Minute mit einer 5000 Watt Metallhalogenidlampe in einem Abstand von 75 cm und dem Entwickeln mit einem 9:1-Volumengemisch aus Toluol und Aceton erhält man ein gutes Bild.

Beispiel 15

40 Teile 2,2-Bis(3-allyl-4-hydroxyphenyl)propan, 50 Teile Harz XI, 10 Teile Harz II, 20 Teile Pentaerythrit-tetra(thioglykolat) und 3 Teile Benzildimethylketal werden miteinander vermischt und dann auf ein kupferkaschiertes Laminat appliziert (Schichtdicke 6 µm). Das beschichtete Laminat wird während 30 Minuten in einer 10 Vol. % Triäthylamindampf in Stickstoff enthaltenden Kammer behandelt, wobei die Beschichtung klebfrei wird. Nach dem Bestrahlen durch ein Negativ mit einer 5000 Watt Metallhalogenidlampe in einem Abstand von 75 cm während 2 Minuten und dem Entwickeln in Aethanol erhält man ein Bild.

**Patentansprüche**

1. Verfahren zur Bilderzeugung umfassend die Schritte:

a) Applikation einer Schicht eines flüssigen Stoffgemisches, das durch Kontakt mit einem gasförmigen Polymerisationsmittel polymerisierbare Reste und lichtvernetzbare Reste enthält, auf ein Substrat,

b) Kontaktieren des Stoffgemisches mit einem gasförmigen Polymerisationsmittel, so dass die Beschichtung sich verfestigt, aber lichtvernetzbar bleibt,

c) Bestrahlen der verfestigten Schicht in einem vorgegebenen Muster mit aktinischem Licht, so dass die belichteten Stellen der Schicht durch Licht vernetzt werden, und

d) Entfernen der im wesentlichen nicht lichtvernetzten Stellen der Schicht durch Behandlung mit einem dafür geeigneten Lösungsmittel.

2. Verfahren nach Anspruch 1, worin das flüssige Stoffgemisch eine Substanz enthält, die in demselben Molekül sowohl polymerisierbare als auch lichtvernetzbare Gruppen aufweist.

3. Verfahren nach Anspruch 1, worin das flüssige Stoffgemisch ein Gemisch aus einem oder mehr Materialien, die im Kontakt mit dem gasförmigen Polymerisationsmittel polymerisieren, und einem oder mehr lichtvernetzbaren Materialien enthält.

4. Verfahren nach Ansprüchen 1—3, worin der polymerisierbare Rest eine einzige Spezies oder zwei oder mehr ähnliche Spezies, die unter dem katalytischen Einfluss des gasförmigen Polymerisationsmittels polymerisieren, enthält.

5. Verfahren nach Anspruch 4, worin der polymerisierbare Rest und das gasförmige Polymerisationsmittel dafür die folgenden sind: ein Cyanacrylat mit Wasserdampf, Ammoniak oder einem Amin, ein Präpolymer mit Isocyanat-Endgruppen mit Ammoniak oder einem Amin, ein Epoxidharz mit Bortrifluorid oder ein phenolisches Harz mit einem sauren Gas.

6. Verfahren nach Anspruch 5, worin der polymerisierbare Rest

i) ein Cyanacrylat der Formel II

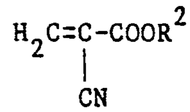

(II),

worin $R^2$ eine Alkyl-, Alkenyl-, Aralkyl-, Halogenalkyl-, Cycloalkyl-, Aryl- oder Alkoxyalkylgruppe mit höchstens 18 C-Atomen ist,

ii) ein Präpolymer mit Isocyanat-Endgruppen, erhalten durch Umsetzung eines Polyols, Polyamins oder einer Polycarbonsäure mit einem aliphatischen, cycloaliphatischen oder aromatischen Diisocyanat,

iii) ein Epoxidharz mit mindestens zwei direkt an ein Sauerstoff-, Stickstoff- oder Schwefelatom gebundenen Gruppen der Formel III

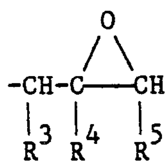

(III)

worin $R^3$ und $R^5$ je ein Wasserstoffatom und $R^4$ ein Wasserstoffatom oder eine Methylgruppe bedeuten oder $R^3$ und $R^5$ zusammen $—CH_2CH_2—$ und $R^4$ ein Wasserstoffatom darstellen,

iv) ein Epoxidharz, in dem einige oder alle Epoxidgruppen nicht endständig sind, oder

v) ein Resol aus einem Phenol und einem Aldehyd ist.

7. Verfahren nach einem der Ansprüche 1—3, worin der polymerisierbare Rest zwei oder mehr miteinander reagierende Spezies aufweist, die relativ stabil sind, bis die Reaktion zwischen diesen Spezies durch das gasförmige Polymerisationsmittel katalysiert oder beschleunigt wird.

8. Verfahren nach Anspruch 7, worin der polymerisierbare Rest und das gasförmige Polymerisationsmittel dafür die folgenden sind: ein Gemisch aus einem Polyol und einem Isocyanat mit Ammoniak oder einem Amin, ein Polyen-Polythiol-Gemisch mit Ammoniak oder einem Amin, ein Epoxidharz/Amin-Gemisch mit einem sauren Gas, ein Epoxidharz/Thiol-Gemisch mit Ammoniak oder einem Amin, oder ein Gemisch aus einem Acrylat oder Methacrylat und Wasserstoffperoxid oder einem freie Radikale bildenden Hydroperoxid mit Schwefeldioxid.

9. Verfahren nach Anspruch 8, worin der polymerisierbare Rest

i) ein Gemisch aus einem Alkylenglykol, einem Polyoxyalkylenglykol, einem Alkantriol, einem hydroxylgruppenhaltigen Reaktionsprodukt aus einem Epoxidharz und einer Carbonsäure, einem Carbonsäureanhydrid, einem Phenol, einem primären oder sekundären Amin oder einem Thiol, Pentaerythrit oder einem hydroxylgruppenhaltigen Polymer eines Hydroxyalkylacrylats oder -methacrylats oder einem Copolymer aus Styrol und Allylalkohol und einem aliphatischen, cycloaliphatischen oder aromatischen Isocyanat,

ii) ein Gemisch aus einem Polyen mit einem Molekulargewicht von 50—20000, das zwei oder mehr äthylenische oder äthynylische, zur Polymerisation in Gegenwart von freien Radikalbildnern befähigte Bindungen aufweist, oder aus einem Epoxidharz gemäss Anspruch 6 und einem Polythiol mit einem Molekulargewicht von 50—20000, wobei das Polythiol ein Ester der Thioglykolsäure, α-Mercaptopropionsäure oder β-Mercaptopropionsäure mit einem Glykol, einem Triol, Tetraol, Pentaol oder Hexol ist,

iii) ein Gemisch aus einem Epoxidharz gemäss Anspruch 6 und einem aliphatischen alicyclischen, ungesättigten heterocyclischen oder araliphatischen tertiären Amin, oder

iv) ein Gemisch aus einem Acrylat- oder Methacrylatmonomer ausgewählt aus Acrylsäure, Methacrylsäure, Alkylacrylaten, Alkylendioldiacrylaten, 1,1,1-Trimethylolpropantriacrylat, Polypropylenglykoldiacrylaten, Allylacrylat oder einem entsprechenden Methacrylat, und Wasserstoffperoxid, tert-Butylhydroperoxid, Cumolhydroperoxid oder 2,4-Dimethyl-2,4-hexandihydroperoxid ist.

10. Verfahren nach einem der vorhergehenden Ansprüche, worin die vorhandenen lichtvernetzbaren Reste solche sind, die durch direkte Aktivierung einer lichtempfindlichen Gruppe mittels Bestrahlung vernetzt werden, und worin das lichtempfindliche Material mindestens zwei Azido-, Cumarin-, Stilben-, Maleinimid-, Pyridinon-, Chalkon-, Propenon-, Pentadienon- oder Anthracengruppen oder Acrylestergruppen aufweist, wobei die Acrylestergruppen in 3-Stellung durch eine äthylenisch ungesättigte Gruppe oder eine aromatische Gruppe in Konjugation mit der äthylenischen Doppelbindung der Acrylgruppe substituiert ist.

11. Verfahren nach Ansprüchen 1—9, worin die vorhandenen lichtvernetzbaren Reste solche sind, worin durch die Bestrahlung ein geeignetes Initiatormolekül aktiviert wird, das dann eine lichtvernetzbare

Gruppe aktiviert, und worin der lichtvernetzbare Rest ein Epoxidharz, ein phenolisches Harz, ein Harnstoff-Formaldehyd-Harz, ein cyclischer Aether, ein cyclischer Ester, ein cyclisches Sulfid, ein cyclisches Amin, eine cyclische Organosiliziumverbindung, ein Ester oder Teilester der Acrylsäure oder Methacrylsäure mit einem aliphatischen einwertigen Alkohol, einem Glykol oder einem höherwertigen Polyol oder mit einer Verbindung mit einer oder mehr Glycidylgruppen, oder ein Ester, erhalten durch Reaktion eines Polyepoxids mit einem Addukt eines Hydroxyalkylacrylats oder -methacrylats mit einem gesättigten oder ungesättigten Polycarbonsäureanhydrid ist.

12. Verfahren nach einem der vorhergehenden Ansprüche, worin das das flüssige Stoffgemisch aufweisende Substrat in einer Kammer angeordnet wird, und die Luft in der Kammer mit dem gasförmigen Polymerisationsmittel ersetzt oder gesättigt wird.

**Revendications**

1. Procédé de formation d'images, comportant les étapes consistant à:

a) appliquer sur un substrat une couche d'un mélange liquide de substances contenant des restes polymérisables par contact avec un agent gazeux de polymérisation, et contenant des restes photoréticulables,

b) mettre le mélange des substances en contact avec un agent gazeux de polymérisation, de sorte que le revêtement se solidifie, mais demeure photoréticulable,

c) exposer la couche ainsi solidifiée, selon un modèle prédéterminé, au rayonnement d'une lumière actinique, de sorte que les endroits exposés et éclairés de la couche sont réticulés par l'action de cette lumière, et

d) enlever de la couche, par traitement à l'aide d'un solvant convenable, les endroits essentiellement non photo-réticulés.

2. Procédé selon la revendication 1, dans lequel le mélange liquide des substances contient une substance qui présente, dans la même molécule, des groupes polymérisables ainsi que des groupes photoréticulables.

3. Procédé selon la revendication 1, dans lequel le mélange liquide des substances contient un mélange d'une ou plusieurs matières, qui polymérise(nt) au contact de l'agent gazeux de polymérisation, et d'une ou plusieurs matières photoréticulables.

4. Procédé selon les revendications 1 à 3, dans lequel le reste polymérisable contient une seule espèce ou deux ou plusieurs espèces semblables qui polymérise(nt) sous l'influence catalytique de l'agent gazeux de polymérisation.

5. Procédé selon la revendication 4, dans lequel le reste polymérisable et l'agent gazeux de polymérisation de ce reste sont les suivants: un cyanacrylate avec de la vapeur d'eau, de l'ammoniac ou une amine, un prépolymère comportant des groupes isocyanates terminaux avec de l'ammoniac ou avec une amine, une résine époxyde avec du trifluorure de bore ou une résine phénolique avec un gaz acide.

6. Procédé selon la revendication 5, dans lequel le reste polymérisable est:

i) un cyanacrylate de formule II

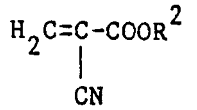

(II),

dans laquelle $R^2$ représente un groupe alkyle, alcényle, aralkyle, halogéno-alkyle, cycloalkyle, aryle ou alcoxyalkyle ayant au maximum 18 atomes de carbone,

ii) un prépolymère comportant des groupes isocyanates terminaux, que l'on obtient par la réaction d'un polyol, d'une polyamine ou d'un acide polycarboxylique avec un diisocyanate aliphatique, cycloaliphatique ou aromatique,

iii) une résine époxyde comportant au moins deux groupes, directement reliés à un atome d'oxygène, d'azote ou de soufre, et répondant à la formule III

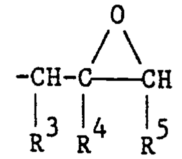

(III)

dans laquelle $R^3$ et $R^5$ représentent chacun un atome d'hydrogène et $R^4$ est un atome d'hydrogène ou un groupe méthyle, ou bien $R^3$ et $R^5$ forment ensemble $-CH_2-CH_2-$ et $R^4$ est un atome d'hydrogène,

iv) une résine époxyde, dans laquelle certains des groupes époxydes, ou tous les groupes époxydes, ne sont pas en position terminale, ou

v) un résol obtenu à partir d'un phénol et d'un aldéhyde.

7. Procédé selon l'une des revendications 1 à 3, dans lequel le reste polymérisable présente deux ou plusieurs espèces pouvant mutuellement réagir, qui sont relativement stables jusqu'à ce que la réaction

entre ces espèces soit catalysée ou accélérée par l'agent gazeux de polymérisation.

8. Procédé selon la revendication 7, dans lequel le reste polymérisable et l'agent gazeux de polymérisation de ce reste sont les suivants: un mélange d'un polyol et d'un isocyanate avec de l'ammoniac ou une amine, un mélange de polyène et de polythiol avec de l'ammoniac ou avec une amine, un mélange résine époxyde/amine avec un gaz acide, un mélange résine époxyde/thiol avec de l'ammoniac ou avec une amine, ou un mélange d'un acrylate ou d'un méthacrylate et de peroxyde d'hydrogène ou d'un hydroperoxyde générateur de radicaux libres avec le bioxyde de soufre.

9. Procédé selon la revendication 8, dans lequel le reste polymérisable est:

i) un mélange d'un alkylèneglycol, d'un polyoxyalkylèneglycol, d'un alcane triol, d'un produit, contenant des groupes hydroxyles, de la réaction d'une résine époxyde et d'un acide carboxylique, un anhydride d'acide carboxylique, un phénol, une amine primaire ou secondaire ou un thiol, le pentaérythritol ou un polymère, contenant des groupes hydroxyles, d'un acrylate ou méthacrylate d'hydroxyalkyle ou un copolymère de styrène et de l'alcool allylique et d'un isocyanate aliphatique, cycloaliphatique ou aromatique,

ii) un mélange d'un polyol, ayant un poids moléculaire de 50 à 20 000, qui présente deux ou plusieurs liaisons éthyléniques ou éthynyliques capables de polymériser en présence de générateurs de radicaux libres, ou un mélange d'une résine époxyde selon la revendication 6 et d'un polythiol ayant un poids moléculaire de 50 à 20 000, le polythiol étant un ester de l'acide thioglycolique, de l'acide alpha-mercaptopropionique ou de l'acide β-mercaptopropionique avec un glycol, un triol, un tétra-ol, un penta-ol ou un hexol,

iii) un mélange d'une résine époxyde selon la revendication 6 et d'une amine tertiaire aliphatique, alicyclique, hétérocyclique ou araliphatique insaturée, ou

iv) un mélange d'un monomère acrylique ou méthacrylique choisi parmi l'acide acrylique, l'acide méthacrylique, des acrylates d'alkyle, des diacrylates d'alkylène diols, du triacrylate de triméthylol-1,1 propane, des diacrylates de polypropylèneglycols, l'acrylate d'allyle ou un méthacrylate correspondant, et le peroxyde d'hydrogène, l'hydroperoxyde de tertiobutyle, l'hydroperoxyde de cumène ou le dihydroperoxyde-2,4 de diméthyl-2,4 hexane.

10. Procédé selon l'une des revendications précédentes, dans lequel les restes photoréticulables présents sont ceux qui deviennent réticulés par activation directe d'un groupe photosensible, par exposition à un rayonnement, et dans lequel la matière photosensible présente au moins deux groupes azido, coumarine, stilbène, maléinimide, pyridinone, chalcone, propénone, pentadiénone ou anthracène, ou des groupes esters acryliques, les groupes esters acryliques étant fixés comme substituants en position 3 grâce à un groupe à insaturation éthylénique ou à un groupe aromatique conjugué à la double liaison éthylénique du groupe acrylique.

11. Procédé selon les revendications 1 à 9, dans lequel les restes photoréticulables présents sont ceux qui sont activés par l'exposition, à un rayonnement, d'une molécule d'un amorceur convenable, laquelle active ensuite un groupe photoréticulable, et dans lequel le reste photoréticulable est une résine époxyde, une résine phénolique, une résine urée-formaldéhyde, un éther-oxyde cyclique, un ester cyclique, un sulfure cyclique, une amine cyclique, un composé cyclique d'organosilicium, un ester ou ester partiel de l'acide acrylique ou de l'acide méthacrylique avec un monoalcool aliphatique, un glycol ou un polyol à valence supérieure ou avec un composé comportant un ou plusieurs groupes glycidyliques, ou un ester, obtenus par réaction d'un polyépoxyde avec un produit d'addition d'un acrylate ou méthacrylate d'hydroxyalkyle avec un anhydre d'acide polycarboxylique, saturé ou insaturé.

12. Procédé selon l'une des revendications précédentes, dans lequel le substrat présentant le mélange liquide des matières est disposé dans une chambre, et l'air de cette chambre est remplacé par l'agent gazeux de polymérisation ou est saturé en cet agent gazeux de polymérisation.

**Claims**

1. A process for the production of an image which comprises the steps:

a) application of a layer of a liquid composition containing a radical that is polymerizable on contact with a gaseous polymerizing agent, and a photocrosslinkable radical, to a substrate.

b) contacting the composition with a gaseous polymerizing agent such that the coating solidifies but remains photocrosslinkable,

c) irradiation of the solidified layer with actinic radiation in a predetermined pattern such that the exposed areas of the layer are photocrosslinked, and

d) removal of those parts of the layer which have not become substantially photocrosslinked by treatment with a solvent suitable therefor.

2. A process according to claim 1, in which the liquid composition contains a substance having polymerizable groups and photocrosslinkable groups in the same molecule.

3. A process according to claim 1, in which the liquid composition contains a mixture of one or more materials that are polymerizable on contact with the gaseous polymerizing agent, and one or more photocrosslinkable materials.

4. A process according to claims 1—3, in which the polymerizable radical comprises a single species or

two or more similar species which polymerize under the catalytic influence of the gaseous polymerizing agent.

5. A process according to claim 4, in which the polymerizable radical and its gaseous polymerizing agent are as follows: a cyanoacrylate with water vapour, ammonia, or an amine, a prepolymer having isocyanate end groups with ammonia or an amine, an epoxy resin with boron trifluoride, or a phenolic resin with an acid gas.

6. A process according to claim 5, in which the polymerizable radical is

i) a cyanoacrylate of the formula II

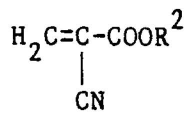

(II),

in which $R^2$ is an alkyl, alkenyl, aralkyl, haloalkyl, cycloalkyl, aryl or alkoxyalkyl group, having at most 18 carbon atoms

ii) a prepolymer having isocyanate end groups and obtained by reaction of a polyol, polyamine, or polycarboxylic acid with an aliphatic, cycloaliphatic or aromatic diisocyanate,

iii) an epoxy resin having at least two groups of the formula III

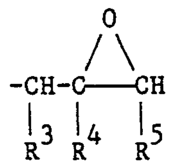

(III)

directly attached to an oxygen, nitrogen or sulfur atom in which formula $R^3$ and $R^5$ are each a hydrogen atom and $R^4$ is a hydrogen atom or a methyl group, or $R^3$ and $R^5$ together are $-CH_2CH_2-$ and $R^4$ is a hydrogen atom,

iv) an epoxy resin in which some or all of the epoxide groups are not in terminal positions, or

v) a resole made from a phenol and an aldehyde.

7. A process according to any one of claims 1—3, in which the polymerizable radical has two or more co-reacting species that are comparatively stable until the reaction between these species is catalysed or accelerated by the gaseous polymerizing agent.

8. A process according to claim 7, in which the polymerizable radical and its gaseous polymerizing agent are as follows: a mixture of a polyol and an isocyanate with ammonia or an amine, a polyene-polythiol mixture with ammonia or an amine, an epoxy resin-amine mixture with an acid gas, an epoxy resin-thiol mixture with ammonia or an amine, or a mixture of an acrylate or methacrylate and hydrogen peroxide or a hydroperoxide free radical initiator with sulfur dioxide.

9. A process according to claim 8, in which the polymerizable residue is

i) a mixture of an alkylene glycol, a polyoxyalkylene glycol, an alkane triol, a hydroxyl group-containing reaction product of an epoxy resin with a carboxylic acid, a carboxylic anhydride, a phenol, a primary or secondary amine, or a thiol, pentaerythritol, or a hydroxyl group-containing polymer of a hydroxyalkyl acrylate or methacrylate or a copolymer of styrene and allyl alcohol with an aliphatic, cycloaliphatic or aromatic isocyanate,

ii) a mixture of a polyene having a molecular weight of 50 to 20,000 and containing two or more ethylenic or ethynylic bonds capable of polymerization in the presence of free-radical formers, or an epoxy resin according to claim 6 with a polythiol having a molecular weight of 50 to 20,000, the polythiol being an ester of thioglycollic acid, α-mercaptopropionic acid or β-mercaptopropionic acid with a glycol, triol, tetraol, pentaol or hexol,

iii) a mixture of an epoxy resin according to claim 6 with an aliphatic, alicyclic, unsaturated heterocyclic or araliphatic tertiary amine, or

iv) a mixture of an acrylate or methacrylate monomer selected from acrylic acid or methacrylic acid, or an alkyl acrylate, alkylene-diol diacrylate, 1,1,1-trimethylolpropane triacrylate, polypropylene glycol diacrylate, allyl acrylate, or a corresponding methacrylate, with hydrogen peroxide, tert-butyl hydroperoxide, cumene hydroperoxide, or 2,4-dimethyl-2,4-hexane dihydroperoxide.

10. A process according to any one of the preceding claims, in which the photocrosslinkable radical present is one which is crosslinked by direct activation of a photosensitive group through irradiation, and in which the photosensitive material has at least two azido, coumarin, stilbene, maleimide, pyridinone, chalcone, propenone, pentadienone, or anthracene groups or acrylic ester groups, the acrylic ester groups being substituted in the 3-position by an ethylenically unsaturated group or an aromatic group in conjugation with the ethylenic double bond of the acrylic group.

11. A process according to claims 1—9, in which the photocrosslinkable radical present is one in which irradiation activates a suitable initiator molecule which then activates a photocrosslinkable group, and in which the photocrosslinkable radical is an epoxy resin, a phenolic resin, a urea-formaldehyde resin, a cyclic

ether, a cyclic ester, a cyclic sulphide, a cyclic amine, an organosilicon compound, an ester or partial ester of acrylic acid or methacrylic acid with an aliphatic monohydric alcohol, a glycol, or a higher functional polyol or with a compound having one or more glycidyl groups, or an ester obtained by reaction of a polyepoxide with an adduct of a hydroxyalkyl acrylate or methacrylate with a saturated or unsaturated polycarboxylic acid anhydride.

12. A process according to any one of the preceding claims, in which the substrate bearing the liquid composition is placed in a chamber and air in the chamber is replaced by, or saturated with, the gaseous polymerizing agent.